# EUROPÄISCHE PATENTSCHRIFT

(11) **EP 0 909 120 B1**
(45) Veröffentlichungstag und Bekanntmachung des Hinweises auf die Patenterteilung: **08.06.2005**
(21) Anmeldenummer: 98118627.3
(22) Anmeldetag: 01.10.1998
(51) Int. Cl.: H05K 7/12

(54) **Gehäuse zur Aufnahme elektronischer Bauelemente**
Housing for electronic components
Boîtier abritant des composants électroniques

(30) Priorität: 11.10.1997 DE 19745014; 07.04.1998 DE 19815490
(43) Veröffentlichungstag der Anmeldung: 14.04.1999
(73) Patentinhaber: Conti Temic microelectronic GmbH, 90411 Nürnberg (DE)
(72) Erfinder: Baur, Richard, 85276 Pfaffenhofen (DE); Wörle, Engelbert, 86556 Kühbach (DE); Fendt, Günter, 86529 Schrobenhausen (DE); Ryll, Jürgen, 63329 Egelsbach (DE)

(56) Entgegenhaltungen:
- FR-A- 2 250 259
- GB-A- 911 445
- US-A- 3 029 057

## Beschreibung

Die Erfindung betrifft ein Gehäuse zur Aufnahme elektronischer Bauelemente nach dem Oberbegriff des Patentanspruchs 1.

Bei der Anordnung von Leiterplatten in einem Gehäuse tritt oftmals das Problem auf, daß bei einer gemischten Bestückung der Leiterplatte mit SMDs (Surface Mount Devices) und bedrahteten Bauelementen zum einen die Leiterplatte und somit auch das Gehäuse über-mäßig groß dimensioniert werden müssen, um die verhältnismäßig großen bedrahteten Bauelemente plazieren zu können. Zum anderen ergibt sich die Schwierigkeit, daß die beiden, sich auf einer Leiterplattenseite befindlichen Bauteilarten nicht mit dem gleichen Lötverfahren auf der Leiterplatte verlötet werden können, weil sich mit dem für SMDs geeigneten Reflowlöten keine bedrahteten Bauteile verlöten lassen.

Man versucht das Problem der Belotung von gemischt bestückten Leiterplatten zu lösen, indem bei bedrahteten Bauelementen ein zusätzlicher Adapter aus Kunststoff zwischen Bauteil und Leiterplatte eingefügt wird, und die Anschlüsse des Bauteils umgebogen werden, so daß sie parallel zur Oberfläche der Leiterplatte verlaufen. Nachteilig ist neben den höheren Kosten, die der Adapter verursacht, daß die Lötverbindungen anfälliger werden gegenüber Vibrationen, die auftreten, wenn die Leiterplatte beispielsweise in einem Kraftfahrzeug eingebaut ist.

Ein Adapter ist aus der DE 295 11 775 U1 bekannt, dort allerdings zum Zwecke einer vereinfachten Fixierung eines wärmeerzeugenden Bauelements an einem Kühlkörper.

Elektrolyt-Kondensatoren können allerdings trotz Adapter nicht ohne weitere Maßnahmen mittels Reflowlöten auf die Leiterplatte aufgelötet werden, da bei den hohen Temperaturen während des Lötvorganges der Elektrolyt-Kondensator durch den in seinem Innern entstehenden Gasdruck zerstört werden kann. Zudem ist damit das Problem, daß bedrahtete Bauelement auf einer Leiterplatte sehr viel teure Leiterplattenfläche belegen und auch ein groß dimensioniertes Gehäuse bedingen, noch nicht gelöst.

Es ist deshalb Aufgabe der Erfindung, eine Anordnung anzugeben, mit der die gemischte Bestückung einer Leiterplatte vermieden wird und die ein weniger groß dimensioniertes Gehäuse zuläßt.

Diese Aufgabe wird durch die Merkmale des Anspruchs 1 gelöst, wonach wenigstens ein weiteres Bauelement vorgesehen ist, das auf einer der Leiterplatte gegenüberliegenden Montagefläche des Gehäuses angeordnet ist und Mittel zur elektrischen Verbindung des Bauelements mit der Leiterplatte vorgesehen sind, wobei als elektrisches Verbindungsmittel zumindest ein mit einem Anschluß des Bauelements verbundener Kontaktstift vorgesehen ist, der über Haltemittel mit der Montagefläche verbunden ist und auf die Leiterplatte führt, und wobei der Kontaktstift zur elektrischen Verbindung mit der Leiterplatte als Einpressstift ausgebildet ist.

Die Vorteile der Erfindung liegen darin, daß trotz gemischter Bestückung einer Leiterplatte mit SMDs und mit bedrahteten elektronischen Bauteilen, die nicht als SMDs hergestellt werden können, wie beispielsweise Kondensatoren, Spulen oder Reedkontaktelemente, auf das aufwendige und mit Qualitätsproblemen behaftete Schwallöten verzichtet werden kann. Zudem erfolgt mittels der neuartigen Verbindungsmittel eine mechanische Fixierung und gleichzeitig eine elektrische Kontaktierung, ohne daß hierzu die Anschlüsse des Bauelements mechanisch gebogen werden müssen. Weiterhin kann die Montage und Kontaktierung der bedrahteten Bauteile vor oder nach dem Lötvorgang erfolgen, so daß der Arbeitsablauf beim Bestücken und Beloten der Leiterplatte flexibel bleibt.

Der Kontaktstift bildet mit den Anschlüssen des Bauelements vorteilhaft eine Schneid-Klemm-Verbindung.

Vorteilhafte Weiterbildungen der Erfindung sind in den weiteren abhängigen Ansprüchen beschrieben.

Zwei Ausführungsbeispiele der Erfindung sind nachstehend ausführlich erläutert und anhand der Figuren dargestellt.

Es zeigen
- Fig. 1a:: eine perspektivische Ansicht eines ersten Ausführungsbeispiels der erfindungsgemäßen Vorrichtung,
- Fig. 1b:: ein Schnittbild der Vorrichtung nach Fig. 1a als in ein Kunststoffgehäuse integriertes Einlegeteil,
- Fig. 2a:: eine perspektivische Ansicht eines zweiten Ausführungsbeispiels der erfindungsgemäßen Vorrichtung im Einbauzustand,
- Fig. 2b:: eine schnittbildliche Darstellung der Vorrichtung nach Fig. 2a,
- Fig. 2c:: eine perspektivische Darstellung einzelner Komponenten nach Fig. 2a und
- Fig. 2d:: eine perspektivische Darstellung der Komponenten nach Fig. 2c im montierten Zustand.

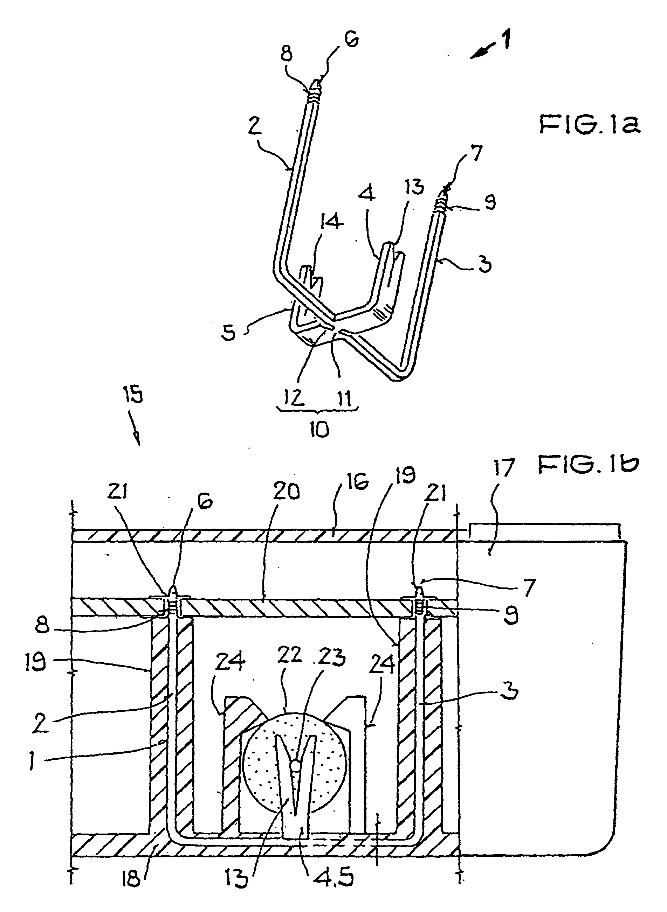

Die **Fig. 1a** zeigt ein als Verbindungsmittel dienendes und erfindungsgemäßes Bauteil **1**, vorzugsweise als ausgestanztes und aus einem Stück bestehendes Blechteil aus Kupferberyllium oder einer anderen Legierung mit ähnlichen mechanischen und elektrischen Eigenschaften, das ein erstes leitfähiges Winkelelement, bestehend aus einem ersten Halteschenkel **2** und einem ersten Anschlußschenkel **4**, und ein zweites leitfähiges Winkelelement, bestehend aus einem zweiten Halteschenkel **3** und einem zweiten Anschlußschenkel **5**, aufweist. Dabei sind jeweils Teilstücke der Halteschenkel **2** und **3** und der Anschlußschenkel **4** und **5** um vorzugsweise 90° abgewinkelt und weisen in die gleiche Richtung. Die Halteschenkel **2** und **3** sind an ihrem jeweils freien Ende als Einpreßstifte ausgebildet und weisen hierzu eine pyramidenförmige Spitze **6** bzw. **7** und eine Rändelung oder Riffelung **8** bzw. **9** auf. Vorzugsweise sind die beiden Halteschenkel **2** und **3** und die beiden Anschlußschenkel **4** und **5** jeweils gleich lang.

Die Längsachsen der beiden nicht abgewinkelten Teilstücke der Halteschenkel **2** bzw. **3** und die Längsachsen der beiden nicht abgewinkelten Teilstücke der Anschlußschenkel **4** bzw. **5** weisen vorzugsweise einen gemeinsamen Schnittpunkt auf und schneiden sich rechtwinklig. Im Bereich dieses Schnittpunktes ist ein Trennelement **10** in Form eines durch einen Steg **11** unterbrochenen Einschnitts **12** in das Bauteil **1** eingebracht.

Die Anschlußschenkel **4** und **5** weisen an ihrem freien Ende jeweils einen Y-förmigen Einschnitt **13** bzw. **14** auf, in den im Einbauzustand ein Anschlußdraht **23** eines zu montierenden elektronischen Bauelements **22** (Fig. 1b) eingeklemmt ist. Damit sich zwischen den Anschlußdrähten **23** des elektronischen Bauelements **22** und den Anschlußschenkeln **4** bzw. **5** eine Schneid-Klemm-Verbindung bildet, sind die den Y-förmigen Einschnitt **13** bzw. **14** bildenden Teilstücke der Anschlußschenkel **4** bzw. **5** als Schneiden ausgebildet.

Die **Fig. 1b** zeigt ein aus Kunststoff bestehendes, schalenförmiges Gehäuse **15**, dessen Schalengrund eine Montagefläche **18** für das Bauelement **22** und das Verbindungsmittel **1**, und weiterhin Seitenwände **17**, einen Einstülpdeckel **16** und Stege **19** aufweist. Innerhalb des Gehäuses **15** ist eine mit elektronischen Bauelementen (nicht dargestellt) bestückte und bereits verlötete Leiterplatte **20** angeordnet, in die kupferkaschierte Bohrungen **21** eingebracht sind. In die Streben **19** des Kunststoffgehäuses **15** sind mittels Insert-Technik die abgewinkelten Teilstücke der Halteschenkel **2** bzw. **3** des Bauteils **1** eingelegt, in den Boden **18** die jeweils nicht abgewinkelten Teilstücke der Halteschenkel **2** und **3** und der Anschlußschenkel **4** und **5.**

Die als Einpreßstifte ausgebildeten Spitzen **6** bzw. **7** der Halteschenkel **2** bzw. **3** sind in die Bohrungen **21** der Leiterplatte **20** eingepreßt. Die Anschlußdrähte **23** eines bedrahteten elektronischen Bauelements **22** sind in die Y-förmigen Einschnitte **13** bzw. **14** der Anschlußschenkel **4** bzw. **5** eingeklemmt. Dadurch ergibt sich sowohl zwischen den Halteschenkeln **2** bzw. **3** und den kupferkaschierten Bohrungen **21** als auch zwischen den Anschlußdrähten **23** und den Anschlußschenkeln **4** bzw. **5** eine Kaltverschweißung als dauerhafte und korrosionsbeständige galvanische Verbindung.

Das Einklemmen der Anschlußdrähte **23** in die Einschnitte **13** und **14** erfolgt vor, während oder nach dem Bestücken der Leiterplatte **20**. Als mechanische Sicherung des bedrahteten Bauelements **22** dienen mit dem Gehäuseboden **18** verbundene Kunststofflaschen **24**, die das bedrahtete Bauelement **22** zangenartig umgreifen und ihm zusätzlichen Halt verschaffen.

Ist der Steg **11** nach der Montage durchtrennt, besteht jeweils zwischen den beiden Halteschenkeln **2** und **3** und zwischen den beiden Anschlußschenkeln **4** und **5** keine galvanische Verbindung mehr, nur noch zwischen dem Halteschenkel **2** und dem Anschlußschenkel **4** bzw. zwischen dem Halteschenkel **3** und dem Anschlußschenkel **5**.

Die mechanische Trennung des Stegs **11** erfolgt vorzugsweise maschinell, nachdem mittels Insert-Technik die abgewinkelten Teilstücke der Halteschenkel **2** und **3** in die Streben **19** des Kunststoffgehäuses **15** und die jeweils nicht abgewinkelten Teilstücke der Halteschenkel **2** und **3** und der Anschlußschenkel **4** und **5** in den Boden **18** des Kunststoffgehäuses **15** eingelegt worden sind. Anschließend wird die aus den Streben **19**, dem Boden **18**, dem Bauteil **1** und dem bedrahteten Bauelement **22** bestehende Baueinheit mit der Leiterplatte **20** verpreßt, wodurch Spitzen **6** und **7** in die Bohrungen **21** der Leiterplatte **20** eingepreßt und dadurch das bedrahtete Bauelement **22** kontaktiert wird.

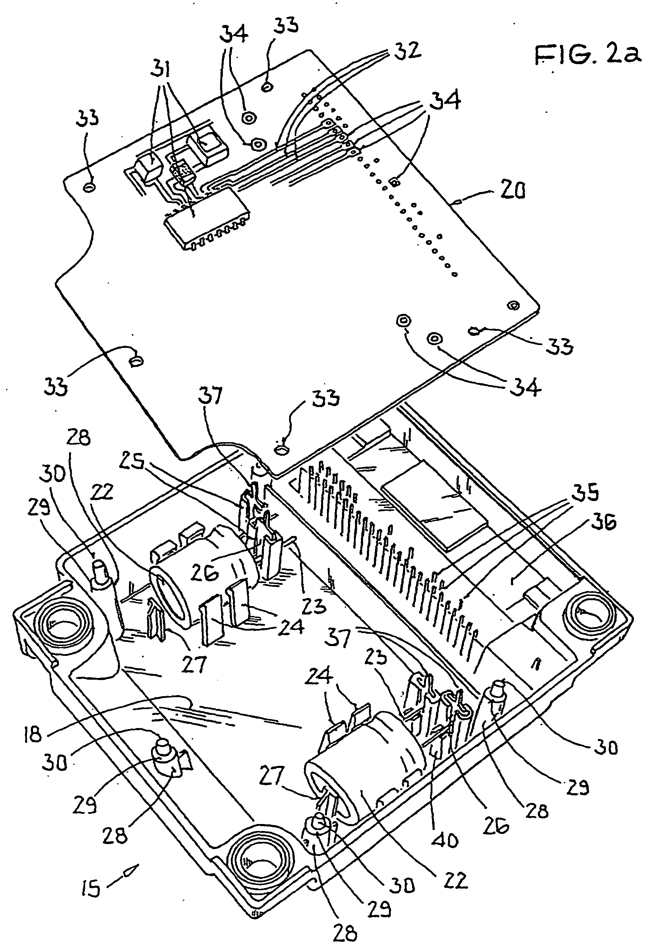

Die **Fig. 2a-d** zeigen eine weitere Möglichkeit, bedrahtete elektronische Bauelemente **22** in das Gehäuse **15** einzubauen und mit der Leiterplatte **20** zu kontaktieren. Hierzu sind außer den zur Befestigung des Bauelements **22** dienenden Kunststofflaschen **24** an den Boden **18** Haltetaschen **25** als Haltemittel zur Aufnahme von Verbindungsmitteln **26** angebracht, beispielsweise durch Anformen, Anspritzen, Kleben oder auf sonstige Art und Weise. Diese Verbindungsmittel **26**, die im weiteren noch genauer beschrieben werden, haben die Aufgabe, die Anschlußdrähte **23** des Bauelements **22** mechanisch und elektrisch zu kontaktieren. Zur genauen Positionierung des Bauelements **22** sind am Boden **18** noch Anschläge **27** vorzugsweise auf genannte Art und Weise angebracht. Ebenfalls an das Gehäuse angeformt sind mehrere stabförmige Stützen **28**, die zur genauen Positionierung nach Höhe und Seite der im Gehäuse **15** angeordneten Leiterplatte **20** dienen. Zur genauen Positionierung nach der Höhe weisen die Stützen **28** eine Abstufung **29** und ein verjüngtes Teilstück **30** auf.

Auf der Leiterplatte **20** sind beidseitig elektronische Bauelemente **31** in SMD-Ausführung angeordnet, die mittels Leitbahnen **32** miteinander verbunden sind. Zudem weist die Leiterplatte **20** Aussparungen **33** zur Positionierung mittels der Stützen **28** innerhalb des Gehäuses **15** auf. Kontaktieröffnungen **34** dienen zur Aufnahme von als Kontakt- oder Einpreßstifte ausgebildeten Steckerpins **35** einer im Gehäuse **15** angeordneten Steckerleiste **36** und der ebenfalls als Kontaktoder Einpreßstifte ausgebildeten Enden **37** der Verbindungsmittel **26**.

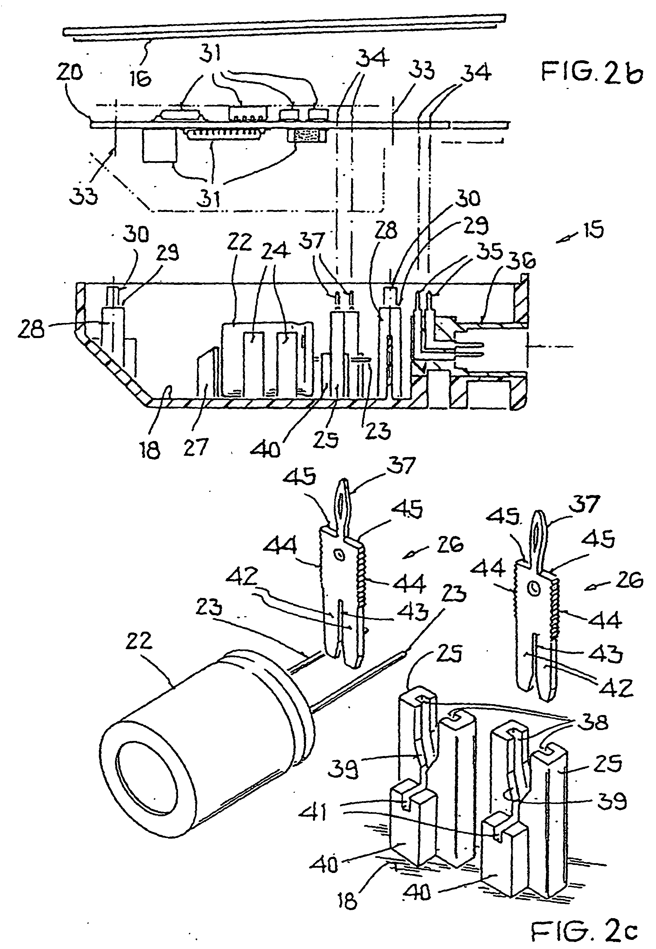

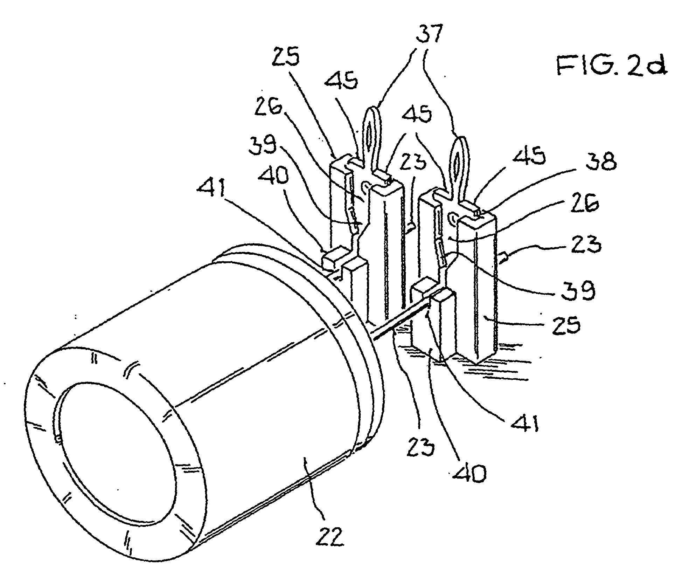

Aus **Fig. 2b** geht die genaue Positionierung der mit SMDs **31** bestückten Leiterplatte **20** im Gehäuse **15** hervor. Bei der Montage wird vorzugsweise maschinell die bestückte Leiterplatte **20** in das Gehäuse **15** eingesetzt, indem die verjüngten Teilstücke **30** in die korrespondierenden Aussparungen **33** eingeführt werden. Dadurch werden auch die Kontakt- bzw. Einpreßstifte **35**, **37** jeweils in die zugehörigen Kontaktieröffnungen **34** eingepreßt (Einpreßtechnik), wodurch eine mechanisch und elektrisch dauerhafte und elektrisch niederohmige Verbindung zustande kommt. Es besteht aber auch die Möglichkeit, die in die Kontaktieröffnungen **34** eingesteckten Kontaktstifte **35**, **37** zu verlöten oder anderweitig elektrisch zu kontaktieren und mechanisch zu befestigen. Zuletzt wird das Gehäuse **15** mit Hilfe des Einstülpdeckels **16** verschlossen.

Das gezeigte Gehäuse weist wichtige Vorteile auf. Dadurch, daß die bedrahteten Bauelemente **22** nicht auf der Leiterplatte **20**, sondern auf dem Boden **18** angeordnet und mittels der Verbindungsmittel **26** mit der Leiterplatte **20** elektrisch verbunden sind, kann die Leiterplatte **20** ausschließlich mit SMDs **31** bestückt werden. Dadurch wiederum kann die Leiterplatte **20** wesentlich kleiner ausfallen, und es entfällt eine aus bedrahteten Bauelementen **22** und SMDs **31** bestehende gemischte Bestückung, so daß nur ein Reflowlötvorgang notwendig ist. Zudem ist die Lage der Stufe **29** der Höhe nach so bemessen, daß über den bedrahteten Bauelementen **22** noch genügend Platz verbleibt, um die Leiterplatte **20** auch auf ihrer Unterseite bestücken zu können. Auch dadurch wird teure Leiterplattenfläche eingespart.

**Fig. 2c** zeigt die zur Herstellung eines elektrischen Kontaktes zwischen bedrahtetern Bauelement **22** und Leiterplatte **20** notwendigen Haltetaschen **25** und Ver bindungsmittel **26.** Bei den Haltetaschen **25** handelt es sich vorzugsweise aus gespritzten Kunststoffteilen, die entweder separat hergestellt und beispielsweise durch Kleben oder auf sonstige Art und Weise mit dem Boden **18** mechanisch verbunden werden, oder die gleichzeitig mit dem Kunststoffgehäuse **15** in einem einzigen Fertigungsgang hergestellt und somit an das Kunststoffgehäuse **15** angeformt werden.

Als Führung für die Verbindungsmittel **26** beim Einschieben weist jede Haltetasche **25** zwei sich gegenüberstehende, U-förmige Führungsnuten **38** auf. deren Breite geringfügig größer ist als die Dicke der Verbindungsmittel **26**. Ein zwischen den Führungsnuten **38** angeordneter, nach oben hin parallel verlaufender und nach unten hin Y-förmig sich zuspitzender Einschnitt **39** erleichtert bei der Montage das Einlegen der Anschlußdrähte **23**. Eine Auflage **40**, die an ihrem oberen Ende einen U-förmigen Schlitz **41** aufweist, dient zum Positionieren und Abstützen der Anschlußdrähte **23** beim Kontaktierungsvorgang.

Die elektrisch leitfähigen Verbindungsmittel **26** weisen in ihrem unteren Bereich zwei sich gegenüberstehende und leicht gegeneinander geneigte Schneiden **42** auf, die durch einen Y-förmigen Spalt **43** voneinander getrennt sind. Die geringste Breite des Spaltes **43** fällt dabei etwas geringer aus als die Dicke der Anschlußdrähte **23**. In ihrem mittleren Bereich weisen die Verbindungsmittel **26** an ihrer Außenseite Z-förmige Widerhaken **44** auf, womit sie sich in den Führungsnuten **38** festhalten. In ihrem oberen Bereich sind die Verbindungsmittel **26** als Kontaktstifte **37**, vorzugsweise als Einpreßstifte, ausgebildet, so daß zusammen mit den Kontaktieröffnungen **34** eine mechanisch stabile und elektrisch gut leitende Verbindung hergestellt ist, wie bereits ausgeführt wurde. Zwischen dem oberen Bereich der Kontakt- bzw. Einpreßstifte **37** und dem mittleren Bereich mit den Widerhaken **44** kann das Verbindungsmittel **26** eine Schulter oder Stufe **45** aufweisen.

Weiterhin kann Im mittleren Bereich der Verbindungsmittel 26 eine Stufe oder Abstufung gebildet werden indem der mittlere Bereich mit den Widerhaken **44** breiter ausgebildet ist als der untere Bereich mit den Schneiden **42**. Die dadurch entstandene Abstufung dient zum einen als Anschlag und garantiert die Maßeinhaltung gegenüber den Anschlußdrähten **23** beim Herstellen der Schneid-Klemm-Verbindung. Zum anderen wird diese Abstufung in Verbindung mit der zugehörigen Haltetasche **25** als Gegenlager beim Einpressen der Kontakt- bzw. Einpreßstifte **37** in die Kontaktieröffnungen **34** genutzt.

In **Fig. 2d** ist die aus bedrahtetem Bauteil **22**, Verbindungsmittein **26** und Haltetaschen **25** bestehende und fertig montierte Baugruppe dargestellt. Der vorzugsweise maschinell getätigte Montagevorgang läuft dermaßen ab, daß zuerst die Anschlußdrähte **23** in den jeweiligen V-förmigen Einschnitt **39** eingelegt werden, so daß sie im U-förmigen Schlitz **41** der Auflage **40** aufliegen. Danach werden die Verbindungsmittel **26** jeweils in die Haltetaschen **25** eingesteckt, geführt durch die U-förmigen Führungsnuten **38**, wodurch zwischen den Anschlußdrähten **23** und den (hier nicht sichtbaren) Schneiden **42** eine gasdichte und damit nicht korrodierende Schneid-Klemm-Verbindung mit einem niedrigen Übergangswiderstand entsteht. Die (hier nicht sichtbaren) Widerhaken **44** verzahnen sich nach dem Einstecken mit den Führungsnuten **38**, so daß eine dauerhaft feste mechanische Verbindung entsteht, die den Anforderungen der Kraftfahrzeughersteller genügt. Ein zusätzlicher Halt der Anschlußdrähte **23** in den Haltetaschen **25** kann dadurch erfolgen, daß die U-förmigen Schlitze **41** durch Warmverstemmen plastisch verformt werden, so daß die Anschlußdrähte **23** ganz oder teilweise umschlossen sind.

Das erfindungsgemäße Gehäuse eignet sich zur Aufnahme wenigstens einer Leiterplatte und bedrahteter, nicht oder nur mit großem Aufwand als SMDs herstellbarer elektronischer Bauelemente. Der Kontaktierungs- und Montageablauf ist flexibel gestaltet und kann maschinell ausgeführt werden.

## Patentansprüche

1. Gehäuse (15) zur Aufnahme von auf wenigstens einer Leiterplatte (20) angeordneten elektronischen Bauelementen (31), **dadurch gekennzeichnet, dass** wenigstens ein weiteres Bauelement (22) vorgesehen ist, das auf einer der Leiterplatte (20) gegenüberliegenden Montagefläche (18) des Gehäuses (15) angeordnet ist und dass Mittel (1; 26) zur elektrischen Verbindung des Bauelements (22) mit der Leiterplatte (20) vorgesehen sind, wobei als elektrisches Verbindungsmittel (1; 26) zumindest ein mit einem Anschluß (23) des Bauelements (22) verbundener Kontaktstift (2, 4; 3, 5; 37) vorgesehen ist, der über Haltemittel (19; 25) mit der Montagefläche (18) verbunden ist und auf die Leiterplatte (20) führt, und wobei der Kontaktstift (2, 4; 3, 5; 37) zur elektrischen Verbindung mit der Leiterplatte (20) als Einpressstift ausgebildet ist.

2. Gehäuse nach Anspruch 1, **dadurch gekennzeichnet, dass** der Kontaktstift (2, 4; 3, 5; 37) zur elektrischen Verbindung mit dem Anschluß (23) des Bauelementes (22) mit einem Schneid-Klemm-Kontakt (42) versehen ist und dass dieser Schneid-Klemm-Kontakt (42) zusammen mit den Haltemitteln (25) eine Schneid-Klemm-Vorrichtung bildet.

3. Gehäuse nach einem der vorangehenden Ansprüche, **dadurch gekennzeichnet, dass** die Montagefläche (18) Halterungen (24) für das Bauelement (22) aufweist.

4. Gehäuse nach einem der vorangehenden Ansprüche, **dadurch gekennzeichnet, dass** das Gehäuse (15) schalenförmig ausgebildet ist und der Schalengrund die Montagefläche (18) aufweist.

## Claims

1. Package (15) for accommodating electronic components (31), said components (31) being arranged on at least one printed circuit board (20), **characterized in that** there is provided at least one further component (22) arranged on a mounting face (18) of the package (15), said mounting face (18) being arranged opposite the printed circuit board (20), and that there are provided means (1; 26) for electrically connecting the component (22) to the printed circuit board (20), wherein the electric connecting means (1; 26) is formed as at least one connector pin (2, 4; 3, 5; 37) connected to a terminal (23) of the component (22), said connector pin (2, 4; 3, 5; 37) being connected to the mounting face (18) by holding means (19; 25) and leading to the printed circuit board (20), and wherein the connector pin (2, 4; 3, 5; 37) is formed as a press-fit pin for electric connection to the printed circuit board (20).

2. Package according to claim 1, **characterized in that** the connector pin (2, 4; 3, 5; 37) is provided with an insulation displacement termination (42) for electric connection to the terminal (23) of the component (22) and that this insulation displacement termination (42) and the holding means (25) together form an insulation displacement apparatus.

3. Package according to any one of the preceding claims, **characterized in that** the mounting face (18) comprises holders (24) for the component (22).

4. Package according to any one of the preceding claims, **characterized in that** the package (15) is tray-shaped and the tray bottom comprises the mounting face (18).

## Revendications

1. Boîtier (15) pour le logement d'éléments électroniques (31) disposés sur une plaquette de circuit imprimé (20) au moins, **caractérisé en ce qu'**au moins un autre élément (22) est prévu, lequel est disposé sur une surface de montage (18) du boîtier opposée à la plaquette de circuit imprimé (20), et **en ce que** des moyens (1 ; 26) pour la connexion électrique de l'élément (22) avec la plaquette de circuit imprimé (20) sont prévus, où au moins une broche de contact (2, 4 ; 3, 5 ; 37) reliée à un raccord (23) de l'élément (22) est prévue comme moyen de connexion électrique (1 ; 26), laquelle est reliée par des moyens de maintien (19 ;25) à la surface de montage (18) et conduit à la plaquette de circuit imprimé (20), et où la broche de contact (2, 4 ; 3, 5 ; 37) est formée en tant que broche à emmancher en force pour la connexion électrique avec la plaquette de circuit imprimé (20).

2. Boîtier selon la revendication 1, **caractérisé en ce que** la broche de contact (2, 4 ; 3, 5 ; 37) pour la connexion électrique avec le raccord (23) de l'élément (22) est munie d'un contact par déplacement d'isolation (42), et **en ce que** ce contact par déplacement d'isolation (42) forme un dispositif à déplacement d'isolation avec les moyens de maintien (25).

3. Boîtier selon l'une des revendications précédentes, **caractérisé en ce que** la surface de montage (18) présente des supports (24) pour l'élément (22).

4. Boîtier selon l'une des revendications précédentes, **caractérisé en ce que** le boîtier (15) est en forme de coque, et **en ce que** le fond de la coque présente la surface de montage (18).
